# EUROPÄISCHE PATENTANMELDUNG

(11) **EP 0 913 503 A1**
(43) Veröffentlichungstag der Anmeldung: **06.05.1999**
(21) Anmeldenummer: 98117018.6
(22) Anmeldetag: 09.09.1998
(51) Int. Cl.: C30B 15/00, C23C 16/44, F27D 17/00

(54) **Vorrichtung zur Abscheidung eines Staubs aus einem Gasstrom**

(30) Priorität: 24.10.1997 DE 19747090
(71) Anmelder: Leybold Systems GmbH, D-63450 Hanau am Main (DE)
(72) Erfinder: Scholler, Johann, 64859 Eppertshausen (DE)

(57) **Zusammenfassung**

Bei einer Staubabscheidevorrichtung (2) zum Ausfiltern von während des beim Kristallziehens aus der Schmelze anfallenden Staubs sind Kaltflächen (42,44a,44b,52,54a,54b,68,69a,69b) als Anströmflächen als Teil der Gasführungsgeometrie vorgesehen, an welcher der Staub aus dem aus der Prozeßkammer abgepumpten Transportgas abscheidbar ist. Durch Kühlung der Anströmflächen (42,44a,44b,52,54a,54b, 68,69a,69b), z. B. mittels eines Kühlmittels, das über mit Ventilen (70a,70b) absperrbaren Kühlmittelleitungen zugeführt wird, wird der Staub besonders effektiv aus dem Transportgas abgefiltert. Die Abscheidevorrichtung (2) weist mehrere, zum Durchlaß und Abfiltern des Staubes aus dem Transportgas hintereinander angeordnete Abscheidekammern (40,50,60) auf. Die einzelnen Abscheidekammern (40,50,60) sind derartig miteinander gekoppelt, daß diese einzeln aus der Abscheidevorrichtung (2), z. B. manuell entnehmbar bzw. in diese einsetzbar sind.

## Beschreibung

Die Erfindung betrifft eine Vorrichtung und ein Verfahren zum Beseitigen von Staub, der insbesondere während der Herstellung eines Kristalls durch Züchtung aus der Schmelze innerhalb einer Schmelzkammer erzeugt wird und der durch einen Gasstrom als Staubbeimischung eines Gases mit diesem aus der Schmelzkammer ableitbar ist.

Bei der Kristallzüchtung aus der Schmelze, wie z.B. beim Czochralski- oder Bridgeman-Verfahren bzw. sonstigen das Kristallausgangsmaterial ein- oder umschmelzenden Verfahren, findet der Schmelzprozeß innerhalb von der Außenatmosphäre abgetrennten Prozeßkammern statt. Die Schmelze wird hierzu z.B. in einem Tiegel gehalten, der sich innerhalb eines auf Unterdruck evakuierbaren Kessel befindet. Entsprechend dem Dampfdruck und der Temperatur des geschmolzenen Materials bildet sich oberhalb des Schmelztiegels eine aus dem Schmelzenmaterial bestehende Dampfwolke aus, die Partikel enthält, die weniger als Mikrometer große Durchmesser aufweisen und welche bevorzugt zu größeren Staubteilchen agglomerieren. Genügend große Staubteilchen können dann in die Schmelze zurückfallen, wodurch eine Störung des Kristallisationsprozesses verursacht wird, und infolge dessen das Einkristallwachstum nachteilig unterbrochen wird. Um dieses zu verhindern, werden die Staubteilchen üblicherweise durch einen kontinuierlichen Gasstrom aus der Prozeßkammer abgeführt. Das hierzu verwendete Gas wird über einen Gaseinlaß in die Prozeßkammer eingelassen, über die Öffnung des Schmelztiegels geleitet, um anschließend zusammen mit dem aufgenommenen Staub von Vakuumpumpen über eine Absaugöffnung abgepumpt zu werden. Aufgrund der stark abrasiven Eigenschaften des abgepumpten Staubs, welcher bei der Züchtung von Si-Einkristallen z. B. aus SiO besteht, wird der Staub üblicherweise in Staubfiltern, welche den Vakuumpumpen vorgeschaltet sind ausgefiltert. Hierzu weisen diese Filter poröse Oberflächen zur Abtrennung und zur Aufnahme der Stäube auf.

Ein Problem in dem Einsatz derartiger bekannter Filter ist, daß deren Kapazitätsgrenze zur Aufnahme von Staub bei starken Staubanfall auch bei großzügiger Auslegung in Bezug zur insgesamt anfallenden Staubmenge schnell erreicht ist und diese porösen Oberflächen dann gegen neue Oberflächen ausgetauscht werden müssen. Hierzu muß üblicherweise entweder die gesamte Filteranordnung zur Entnahme des Filters stillgelegt werden und der Gasstrom durch eine zweite, separate Filteranordnung geführt werden oder der Filter entsprechend der maximal anfallenden Staubmenge ausgelegt werden. Beide Alternativen sind nachteilig konstruktiv aufwendig und mit hohen Kosten verbunden. Weiterhin ist die manuelle Handhabung dieser mit Staub besetzten Filterelemente mit gesundheitlichen Risiken verbunden, die wiederum nur mit zusätzlichem apparativen Aufwand zu umgehen sind. Aufgabe der vorliegenden Erfindung ist es daher, ein Verfahren zum Reinigen von bei der Kristallzüchtung von Kristallen aus Schmelzen verwendeten Spülgasen anzugeben, das einfach durchzuführen und wirtschaftlich anwendbar ist sowie eine hierfür geeignete Filtervorrichtung zur Abtrennung der Staubbeimengungen des Spülgases zu schaffen, welche eine hohe Kapazitätsgrenze aufweist und welcher in konstruktiv einfacher Weise herstellbar und auch eine einfache Handhabung besitzt.

Gelöst wird diese Aufgabe erfindungsgemäß dadurch, daß zum Abtrennen der Staubbeimischungen des Spülgases eine Staubabscheidevorrichtung vorgesehen ist, welche mindestens eine Kammer mit einer kühlbaren Wandfläche aufweist an welche das aus der Prozeßkammer abgepumpte, mit Staub beladene Spülgas derartig anströmbar ist, daß die Staubteilchen bei Kontakt mit der Kammerwand an dieser haften bleiben und somit aus dem Gasstrom entfernt werden. Mit der erfindungsgemäßen Abscheidevorrichtung sind vorteilhaft auch große Staubmengen aus dem Gasstrom abtrennbar, da ein Zusetzen der Filter und eine Erschöpfung der Filterwirkung wie bei einem porösen Siebfilter nicht auftreten kann. Der abgetrennte Staub wird an der gekühlten Wandfläche gebunden und wächst in Schichten langsam auf dieser auf. Hierdurch wird vorteilhaft die Standzeit zwischen zwei erforderlichen Reinigungsvorgängen deutlich gegenüber herkömmlichen Staubfilteranordnungen erhöht.

Die Abscheidekammer selbst weist in ihrer vorzugsweise allseitig gekühlten Kammerwandung eine Gaseintrittsöffnung zum Einlaß des staubbeladenen Gasstroms und eine Gasauslaßöffnung zum Auslaß des gereinigten Gases auf (siehe Anspruch 3). Die begrenzenden Kammerwände sind entsprechend einem weiteren Merkmal derartig zueinander angeordnet, daß die Gasführungsgeometrie den Gasstrom an mindestens eine gekühlte Kammerwandfläche anströmen läßt, an welcher der Staub haften bleibt.

Um eine effektive Kühlung der Wandflächen zu bewirken, ist wie in Anspruch 2 vorgesehen, die Abscheidekammer mit einem doppelwandigen Kühlmantel hergestellt, dessen innerer Kammerwand als Anströmfläche für das staubbeladene Spülgas dient. Der Kühlmantel weist dann, wie in Anspruch 5 beansprucht, einen Kühlmitteleinlaß und einen Kühlmittelauslaß auf, durch welche das Kühlmittel in den Kühlmantel einströmt und in Kontakt mit den Wandflächen diese kühlt um anschließend über ein mit dem Kühlmittelauslaß verbundenen Ableitungskanal abgeleitet zu werden. Sowohl der Kühlmitteleinlaß als auch der Kühlmittelauslaß ist jeweils über ein Absperrventil mit der Kühlmittelzuleitung bzw. der Kühlmittelableitung verbunden (siehe Anspruch 5).

Die Abscheidekammer ist vorteilhaft einteilig gefertigt, wodurch diese, z.B. zum Reinigen der mit Staub belegten Kühlflächen, komplett aus der Gasabpumpleitung entnehmbar ist. Ein Auswechseln einzelner in einer Filterkammer eingesetzter Filterelemente, das üblicherweise zu nicht erwünschten Staubaufwirbelungen führt, wird hierdurch vorteilhaft vermieden.

Um das Auswechseln der Kammer, ohne daß weitere Maßnahmen an der Kühlmittelzufuhr selbst vorzunehmen sind, zu ermöglichen, wird vorgeschlagen (siehe Anspruch 5) in der Kühlmittelzuflußleitung und in der Kühlmittelabflußleitung jeweils ein Ventil, vorzugsweise ein Absperrventil, einzusetzen, welche bei Entnahme der Abscheidekammer aus der Staub den Kühlmittelfluß selbsttätig unterbrechen. Hierzu sind die Ventile gemäß den in Anspruch 8 angegebenen, erfindungsgemäßen Merkmalen ausgebildet.

Ein weiterer Vorteil der Erfindung ergibt sich bei Anordnung von mindestens zwei Kammern derartig hintereinander, daß der Gasstrom zunächst durch die erste und anschließend durch die zweite Kammer gelenkt wird. Durch die Verdopplung der gekühlten Staubabscheideflächen wird die Standzeit der einzelnen Kammern zwischen zwei erforderlichen Reinigungsvorgängen verdoppelt. Die einzelnen Kammern sind hierbei, wie in den Merkmalen des Patentanspruchs 6 angegeben vorzugsweise manuell miteinander lösbar verbunden und können vorteilhaft einzeln zum Reinigen aus der Abscheidevorrichtung vollständig entnommen werden ohne das der abgefilterte Staub in die Umgebung entweicht und wobei der Kühlmittelzufluß zu den übrigen Kammern vorteilhaft nicht unterbrochen wird. Die anschließende Reinigung der Anströmflächen kann dann erfindungsgemäß außerhalb des Bereichs der Kristallzuchtanlage störungsfrei für dessen Betrieb erfolgen.

Zur erfindungsgemäßen, verfahrensgemäßen Verwendung der erfindungsgemäßen Abscheidevorrichtung wird der bei der Kristallzüchtung aus der Schmelze anfallende, nicht umgesetzte Staubanteil zunächst von einem in den Prozeßraum eingeleiteten Spülgas aufgenommen und zusammen mit dem Spülgas entsprechend der Gasführungsgeometrie im Reaktionsvolumen, welche durch die Position des Gaseinlasses und der Gasabsaugung bezüglich des Aufschmelztiegels bestimmt ist, aus dem Prozeßraum herausgespült. Als Spülgas werden vorzugsweise Edelgase, wie z. B. Argon verwendet, welche mit dem Schmelzgut selbst chemisch nicht reagieren. Das Staub-Gasgemisch wird durch eine Abpumpleitung mittels einer Vakuumpumpe aus dem Prozeßraum herausgepumpt, wobei zwischen der Ansaugöffnung der Vakuumpumpe und der Gasauslaßöffnung der Schmelzkammer die erfindungsgemäße Staubabscheidevorrichtung angeordnet ist, durch welche das zu filternde Gas hindurchgeführt wird. Das mit Staub belastete Gas wird in der Abscheidevorrichtung erfindungsgemäß gegen vorzugsweise gekühlte Kammerflächen gelenkt, an welchen die Staubteilchen haften bleiben.

Um Verwirbelungen und Staubaufwirbelungen innerhalb der Abscheidevorrichtung an rauhen Anströmflächen zu vermeiden, weisen die Kühlflächen glatte, vorzugsweise polierte Oberflächen auf. Durch die vorgesehene, vorteilhaft niedrige Temperatur der Oberflächen und ihre geringe Rauigkeit haften die Staubteilchen fest an diesen an, wodurch die Staubabfilterung effektiv erfolgt. Die Reinigung der mit Filterstaub belegten Kühlflächen ist vorteilhaft i einfacher und effektiver Weise möglich, da sich der anhaftende Filterstaub von den polierten Kühlflächen leicht ablösen läßt.

Ein weiterer Vorteil in der Verwendung polierter Oberflächen ist, daß sich diese in besonders einfacher Weise reinigen lassen, wobei an den Kühlflächen verbleibende Restanhaftungen von Staub vollständig vermieden werden. Aufwendige Reinigungsprozeduren, wie bei strukturierten Oberflächen erforderlich, entfallen erfindungsgemäß vorteilhaft.

Das derartig von den Staubteilchen befreite Gas wird dann durch die, den Abscheidevorrichtungen nachgeordneten Pumpen, vorzugsweise Vakuumpumpen kontinuierlich aus dem Prozeßraum abgepumpt und kann anschließend als wiederaufbereitetes Spülgas wieder in der Prozeßraum zurückgeführt werden, wobei innerhalb des Prozeßraums Drücke von 1·10⁻⁵ mbar bis 1·10⁻⁴ mbar in einem dynamischen Druckgleichgewicht aufrechterhalten werden.

Vorteilhafte Ausgestaltungen der erfindungsgemäßen Abscheidevorrichtung sind in den Unteransprüchen mit ihren kennzeichnenden Merkmalen näher beschrieben.

Weitere Vorteile ergeben sich aus einem besonders bevorzugten, in Zeichnungen dargestellten und nachfolgend beschriebenen Ausführungsbeispiel.

Es zeigen:
- Fig. 1: einen Staubabscheider mit drei einzelnen, kaskadierend zueinander angeordnete Abscheidekammern in Querschnittsansicht,
- Fig. 2: die in Fig. 1 dargestellte Abscheidevorrichtung in Schnittansicht entlang der in Fig.1 eingezeichneten Schnittlinie A-B,
- Fig. 3: das in Fig.1 dargestellte Ausführungsbeispiel in Draufsicht mit Teilschnittansicht eines Kühlmittelventils und einer Kühlmittelzuleitung in Durchlaßstellung und
- Fig. 4: einen vergrößerten Ausschnitt der Darstellung der Schnittansicht in Fig. 3.

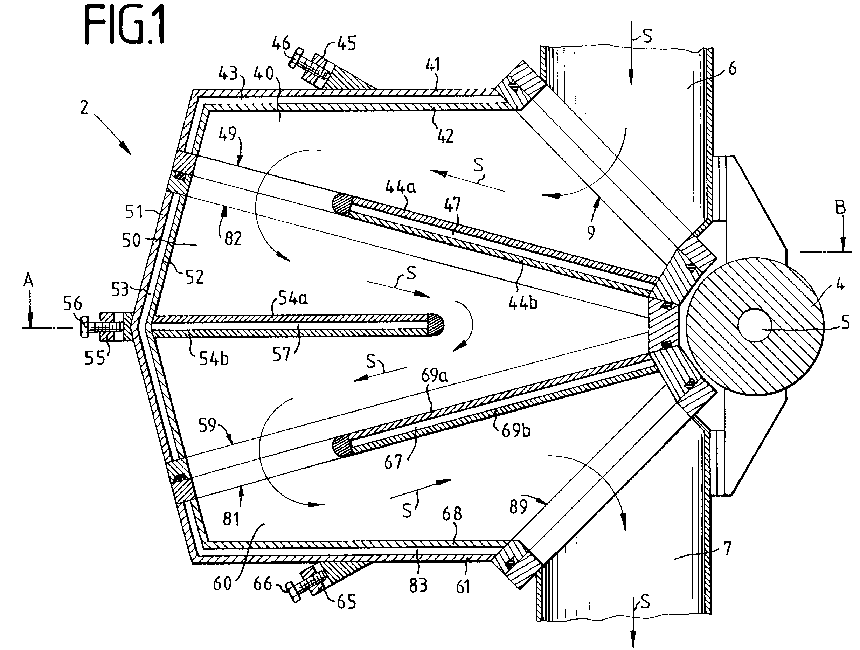

Der in Fig. 1 dargestellte Staubabscheider 2 besteht im wesentlichen aus drei einzelnen Abscheidekammern 40,50,60, welche derartig hintereinander angeordnet sind, daß das mit Staub angereicherte Spülgas entsprechend der schematisch angedeuteten Gasflußrichtung S durch die drei Abscheidekammern 40,50,60 nacheinander hindurchtritt. Hierzu ist die erste Abscheidekammer 40 mit ihrer Gaseinlaßöffnung 9 an der, mit einer in der Zeichnung nicht dargestellten Prozeßkammer verbundenen Absaugleitung 6 angeflanscht. Die Austrittsöffnung 49 der Abscheidekammer 40 mündet in die Eintrittsöffnung 82 der Abscheidekammer 50, deren Austrittsöffnung 59 gegenüber der Eintrittsöffnung 81 der dritten Abscheidekammer 60 angeordnet ist. Die Austrittsöffnung 89 der Abscheidekammer 60 ist an eine Abpumpleitung 7 angeschlossen, welche mit einer in den Figuren nicht dargestellten Vakuumpumpe abpumpbar ist. Der gesamte Staubabscheider 2 ist z.B. benachbart zu einer in den Figuren nicht dargestellten Kristallzuchtanlage angeordnet.

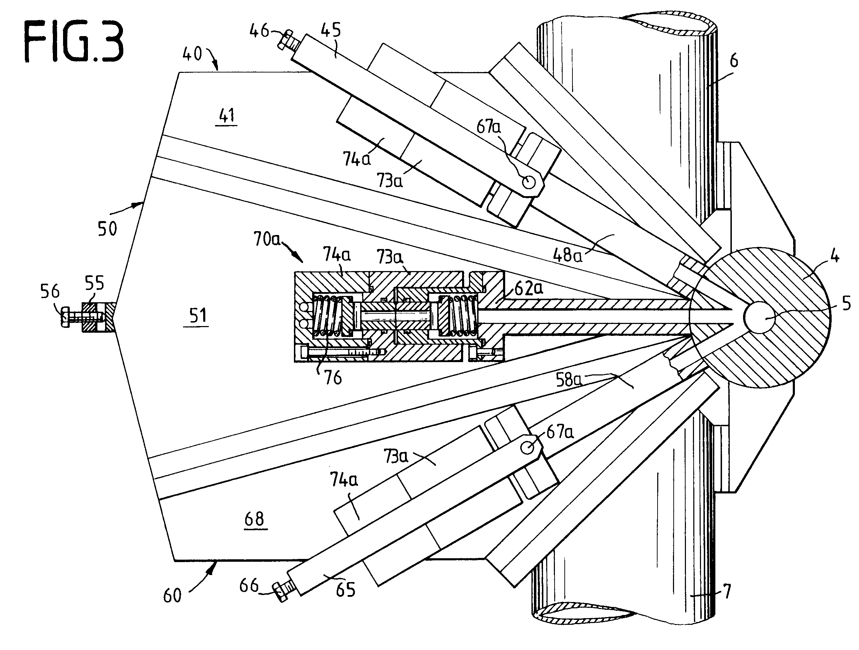

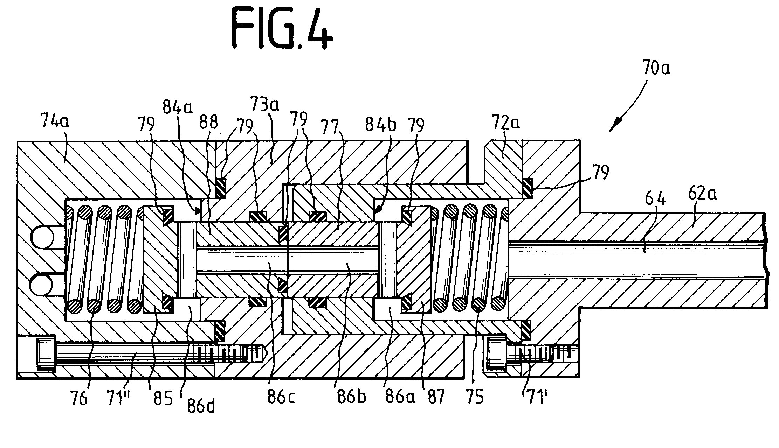

Die Abscheidekammern 40,50,60 sind jeweils allseitig doppelwandig ausgeführt, bestehend aus jeweils einer Kammeraußenwand 41,51,61 und einer Kammerinnenwand 42,52,68, wobei zwischen der Kammeraußenwand 41,51,61 und der zugeordneten Kammerinnenwand 42,52,68 jeweils ein Wandkanal 43,53,83 ausgebildet ist, durch welche ein Kühlmittel hindurchfließt. Das Kühlmittel wird den einzelnen Wandkanälen 43,53,83 jeweils durch einen in Führungsrohren 48a,58a,62a (siehe Fig. 3) ausgebildeten Zuleitungskanal 64 (siehe Fig. 4), wie im Detail anhand des Führungsrohrs 62 beispielhaft dargestellt, über Führungsrohre zentral aus dem Kühlmittelkanal 5 eines Kühlmittelverteilers 4 zugeführt. Zwischen dem Kühlmittelkanal 5 und den einzelnen Wandkanälen 43,53,83 sind in den Führungsrohren 48a,58a,62a Absperrventile 70a (siehe Fig. 3, Fig. 4) eingesetzt.

Die Ventile 70a,70b bestehen, wie exemplarisch aus Fig. 4 ersichtlich, jeweils im wesentlichen aus drei Bauteilen, nämlich einem Ventilkopf 74a, welcher auf der jeweiligen äußeren Kammeraußenwand 41,51,61 fest positioniert ist, einem Führungsgehäuse 73a, welches wiederum an dem Ventilkopf 74a fest angeflanscht ist und dem fest mit dem jeweiligen Führungsrohr 48a,58a,62a verbundenen Ventilzapfen 72a, wobei das Führungsgehäuse 73a axial auf den Ventilzapfen 72a verschiebbar aufsteckbar ist.

Die Führungsrohre 48a,58a,62a sind einerends mit dem Kühlmittelverteiler 4 verbunden und münden mit ihrem Zuleitungskanal 64 andernends jeweils in den Ventilzapfen 72a (siehe Fig. 4), der stirnseitig an dem Führungsrohr 48a,58a,62a und mit einem zwischengelagerten Dichtungselement 79 angeschraubt ist. Der Zuleitungskanal 64 des Führungsrohres 62a geht innerhalb der Ventils 70a in den Ventilkanal 86a über und ist in Durchlaßstellung des Ventils 70a (siehe Fig. 4) mit dem Ventilkanal 86b und dem Ventilkanal 86c des Führungsgehäuses 73a und weiter mit dem Ventilkanal 86d des Ventilkopfes 74a verbunden. Das Ventil 70a befindet sich nur dann in seiner zur Durchleitung des Kühlmittels notwendigen Durchlaßstellung wenn, wie in Fig. 4 dargestellt, das Führungsgehäuse 73a in der in Fig. 4 dargestellten axialen Position auf dem Ventilzapfen 72a aufgesteckt ist. Hierbei werden ein axial in dem Ventilzapfen 72a verschiebbarer Schließbolzen 77 sowie ein axial in dem Führungsgehäuse 73a gelagerte Schließbolzen 88 mit ihren Stirnseiten entgegen der durch die an ihren Rückseiten jeweils andrückenden Druckfedern 75,76 ausgeübten Federkraft gegeneinander gedrückt. Hierdurch werden jeweils an den Schließbolzen 77,88 endseitig fest angeordnete Dichtteller 85,87 von den Dichtflächen 84a,84b des Führungsgehäuses 73a abgehoben, wodurch der Ventilkanal 86a,86b,86c,86d für das Kühlmittel durchgängig wird.

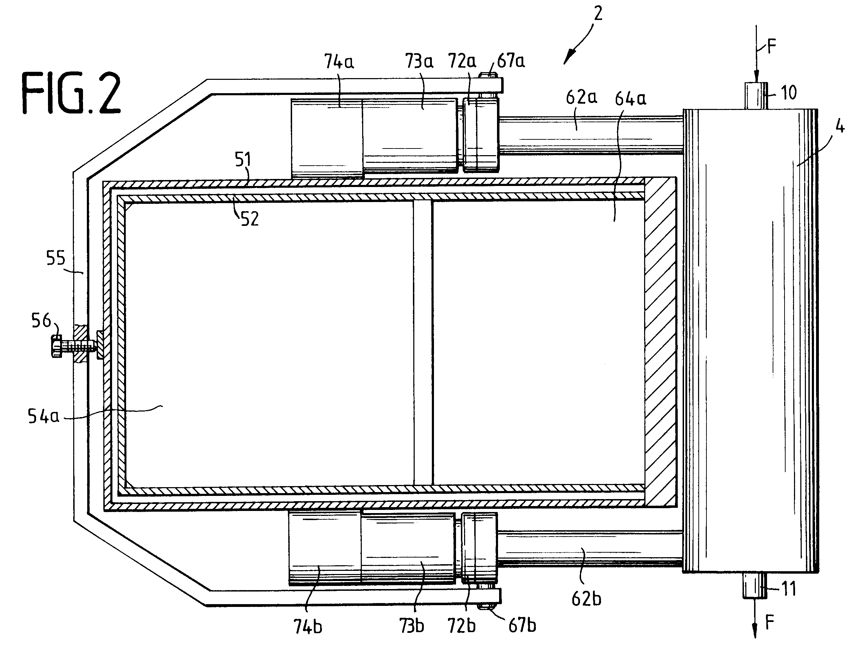

Um das in den Wandkanal 42,52,83 eingeleitete und z. B. als Kühlmittel verwendete, auf Zuleitungstemperatur gekühlte Wasser abzuleiten, sind den für die Kühlmittelzuleitung verwendeten Ventilbauteilen 62a,73a,74a jeweils baugleiche Ableitungskanäle zugeordnet, von denen nur der Ableitungskanal 62b in Figur 2 dargestellt ist. Dieser Ableitungskanal 62b ist mit dem Wandkanal 53 einerends und dem Kühlmittelkanal 5 andernends verbunden. Die sowohl in den Kühlmittelzuleitungen wie auch in den Kühlmittelableitungen und den Vakummverbindungen vorgesehenen Dichtungselemente 79 bestehen z. B. aus elastomeren Material, welche in Nuten lagern, welche insbesondere bei den lösbaren Vakuum- bzw. Kühlmittelverbindungen derartig ausgeführt sind, daß ein unbeabsichtigtes Herausfallen der Dichtungselemente 79 verhindert wird.

Zum Entnehmen der Abscheidekammern 40,50,60 aus dem Staubabscheider 2 wird zunächst eine, in einem, jeweils die Abscheidekammern 40,50,60 schwenkbar umgreifenden zugeordneten Bügel 45,55,65 eingeschraubte Druckschraube 46,56,66 gelöst und der der jeweiligen Abscheidekammer 40,50,60 zugeordnete Bügel 45,55,65 aus dem Bereich der jeweiligen Abscheidekammer 40,50,60 geschwenkt. Die einzelne Abscheidekammer 40,50,60 kann nunmehr zusammen mit dem zugeordneten Ventilkopf 74a, 74b und dem Führungsgehäuse 73a,73b von dem Ventilzapfen 72a,72b und den Führungsrohren 62a,62b einzeln abgezogen werden. Die z. B. der Abscheidekammer 40 zugeordneten Ventile 70a,70b sperren dabei automatisch mit Hilfe der vorgespannten Druckfedern 75,76 den Kühlmitteldurchfluß ab.

In analoger Vorgehensweise sind die Abscheidekammer 50 bzw. 60 aus dem Staubabscheider 2 einzeln entnehmbar.

Beim Wiedereinsetzen z. B. der Abscheidekammer 40 wird umgekehrt wie bei der Entnahme vorgegangen. Der Kühlmitteldurchfluß durch den Zuleitungskanal 64 des Führungsrohres 62a wird dann, wie oben beschrieben ohne weiteres Zutun durch Öffnen der Ventile 70a,70b wieder hergestellt.

### Bezugszeichenliste

- 2: Staubabscheider
- 4: Kühlmittelverteiler
- 5: Kühlmittelkanal
- 6: Absaugleitung
- 7: Abpumpleitung
- 9: Einlaßöffnung
- 10: Kühlmitteleinlaß
- 11: Kühlmittelauslaß
- 40: Abscheidekammer
- 41: Kammeraußenwand
- 42: Kammerinnenwand, Kaltfläche
- 43: Wandkanal
- 44a, 44b: Kaltfläche
- 45: Bügel
- 46: Druckschraube
- 47: Kühlmittelkanal
- 48a: Führungsrohr
- 49: Austrittsöffnung
- 50: Abscheidekammer
- 51: Kammeraußenwand
- 52: Kammerinnenwand, Kaltfläche
- 53: Wandkanal
- 54a, 54b: Kaltfläche
- 55: Bügel
- 56: Druckschraube
- 57: Kühlmittelkanal
- 58a: Führungsrohr
- 59: Austrittsöffnung
- 60: Abscheidekammer
- 61: Kammeraußenwand
- 62a,62b: Führungsrohr, Ventilbauteil
- 64a: Zuleitungskanal
- 65: Bügel
- 66: Druckschraube
- 67: Kühlmittelkanal
- 67a, 67b: Achse
- 68: Kammerinnenwand, Kaltfläche 69a, 69b Kaltfläche
- 70a,70b: Ventil
- 71',71'': Schraube
- 72a,72b: Ventilzapfen
- 73a,73b: Führungsgehäuse, Ventilbauteil
- 74a,74b: Ventilkopf, Ventilbauteil
- 75: Druckfeder
- 76: Druckfeder
- 77: Schließbolzen
- 78: Schließbolzen
- 79: Dichtungselement
- 81: Eintrittsöffnung
- 82: Eintrittsöffnung
- 83: Wandkanal
- 84a,84b: Dichtfläche
- 85: Dichtteller
- 86a,86b,86c,86d: Ventilkanal
- 87: Dichtteller
- 88: Schließbolzen
- 89: Austrittsöffnung
- S: Gasflußrichtung
- F: Kühlmittelflußrichtung

## Patentansprüche

1. Vorrichtung zum Beseitigen von Staub, der insbesondere während der Herstellung eines Kristalls durch Züchtung aus der Schmelze erzeugt wird und der als Staubbeimischung zu einem Transportgas zusammen mit diesem aus der Schmelzkammer ableitbar ist**, gekennzeich****net** **durch** mindestens eine vom Staub-Gasgemisch durchströmbare Abscheidekammer (40,50,60) mit mindestens einer Wandfläche (42,52,68) an welche das Staub-Gasgemisch derartig anströmbar ist, daß der Staub bei Kontakt mit der Wand (42,52,68) an dieser haften bleibt, wodurch der Staub aus dem Gasgemisch abgeschieden wird.

2. Vorrichtung nach Anspruch 1, **dadurch gekennzeichnet,** daß die Wandfläche(42,52,68) als Teil einer vorzugsweise doppelwandig ausgebildeten Kammerwand (41,42;51,52;61,68) kühlbar ist, wobei die Kammerwand (41,42;51,52;61,68) einen Wandkanal (43,53,83) aufweist, in welchen ein Kühlmittel eingebracht ist.

3. Vorrichtung nach Anspruch 1 und /oder 2, **dadurch gekennzeichnet,** daß die Kammerwand (41,42;51,52;61,68) allseitig doppelwandig ausgebildet ist und eine Gaseintrittsöffnung (9,81,82) und eine Gasaustrittsöffnung (49,59,89) aufweist.

4. Vorrichtung nach einem der Ansprüche 1 bis 3, **dadurch gekennzeichnet,** daß der Staubabscheider (2) mindestens zwei in Folge hintereinander angeordnete Abscheidekammern (40,50), (50,60) aufweist, wobei jeweils die Gasaustrittsöffnung (49,59) der einen mit der Gaseintrittsöffnung (53,81) der nachgeordneten Abscheidekammer (50,60) zur Durchleitung und Staubabfilterung des Transportgases verbunden ist.

5. Vorrichtung nach mindestens einem der Ansprüche 1 bis 4, **dadurch gekennzeichnet,** daß die Kammeraußenwand (41;51;61) jeweils mindestens einen Kühlmitteleinlaß und einen Kühlmittelauslaß aufweist, welche jeweils über ein Ventil (70a,70b) mit einem Kühlmittelkanal (47,57,67) verbunden sind.

6. Vorrichtung nach mindestens einem der Ansprüche 1 bis 5, **dadurch gekennzeichnet,** daß die Abscheidekammern (40,50,60) jeweils voneinander lösbar miteinander gekoppelt sind, wodurch die Abscheidekammern (40,50,60) einzeln aus der Abscheidevorrichtung (2) entnehmbar sind.

7. Vorrichtung nach mindestens einem der Ansprüche 1 bis 6, **dadurch gekennzeichnet,** daß die Ventile (70a,70b) zwischen das Kühlmittel zu den Wandkanälen (43,53,83) leitenden Zuleitungskanälen (64) von Führungsrohren (62a,62b), welche mit dem Kühlmittelkanal (5) eines raumfesten Kühlmittelverteilers (4) verbunden sind, und der Kühlmitteleinlaßöffnung der Wandkanäle (43,53,83) verbunden sind.

8. Vorrichtung nach mindestens einem der Ansprüche 1 bis 7, **dadurch gekennzeichnet,** daß die Ventile (70a,70b) im wesentlichen jeweils aus einem Ventilzapfen (72a,72b), einem Führungsgehäuse (73a,73b) und einem am Führungsgehäuse (73a,73b) angekoppelten Ventilkopf (74a,74b) bestehen, wobei der Ventilzapfen (72a,72b) mit dem Führungsrohr (62a,62b) verbunden ist, und wobei das Führungsgehäuse (73a,73b) auf dem Ventilzapfen (72a,72b) aufsteckbar ist, wodurch das Kühlmittel vom Kühlmittelkanal (5) durch das Ventil (70) in den Wandkanal (43,53,83) ein- bzw. aus diesem ableitbar ist.

9. Vorrichtung nach mindestens einem der Ansprüche 1 bis 8, **dadurch gekennzeichnet,** daß die Ventile (70a,70b) derartig als Absperrventil ausgebildet sind, daß bei Trennung des Führungsgehäuses (73a,73b) vom Ventilzapfen (72a,72b) die Ventile (70a,70b) sperren, wodurch der Kühlmittelfluß durch den Kühlmittelkanal (64) sowie zum und aus dem Wandkanal (43,53,83) unterbrechbar ist.
